# EUROPEAN PATENT SPECIFICATION

(11) **EP 3 313 158 B1**
(45) Date of publication and mention of the grant of the patent: **20.01.2021**
(21) Application number: 16840549.6
(22) Date of filing: 17.03.2016
(51) Int. Cl.: A63B 43/00, A63B 45/00, H05K 7/14

(54) **DEVICE FOR MOUNTING CIRCUIT MODULE AND BATTERY IN BALL AND MANUFACTURING METHOD THEREFOR**
VORRICHTUNG ZUR MONTAGE EINES SCHALTUNGSMODULS UND EINER BATTERIE IN EINEM BALL UND HERSTELLUNGSVERFAHREN DAFÜR
DISPOSITIF POUR MONTAGE DE MODULE DE CIRCUIT ET BATTERIE DANS UNE BILLE ET SON PROCÉDÉ DE FABRICATION

(30) Priority: 02.09.2015 CN 201510555887
(43) Date of publication of application: 25.04.2018
(73) Proprietor: Gengee Technology Co., Ltd., Xiamen, Fujian 361000 (CN)
(72) Inventor: KUO, Dai-sung, Xiamen Fujian 361000 (CN)
(74) Representative: Verscht, Thomas Kurt Albert
(86) International application number: PCT/CN2016/076603
(87) International publication number: WO 2017/036119

(56) References cited:
- CN-A- 105 101 732
- CN-U- 202 516 311
- CN-U- 203 507 546
- CN-U- 204 887 818
- US-A1- 2008 220 948
- US-A1- 2012 058 845
- US-A1- 2012 142 443

## Description

### Field of the invention

The present invention relates to a component and an application used to assemble electric module in a ball, particularly to a device used to assemble a circuit module and a battery in a ball and a manufacturing method thereof.

### Background of the invention

With the development of intelligentization in varies fields, sports instruments enter the era of the all-round intelligentization. Therein, for a ball, like a basketball or football, built-in sensors and necessary circuit modules are disposed in the ball to collect sports data. The ball interior is formed by vulcanization in high temperature, but high temperature damages battery even results in explosion. Therefore, in existing technology of manufacturing a ball with built-in circuit and battery, the interior is firstly vulcanized and then the battery is put into a fixing position of the ball, and is wrapped by a leather layer to form the ball body. Said manufacturing method makes the ball body with weak elasticity in the fixing position, the normal usage of the ball is influenced.

With regard to the prior art attention is drawn to US 2012/058845 A1 from which methods and materials for securely retaining electronic components within an inflatable object are known. For example, basketballs having a boot structure for securely retaining one or more electronic components (e.g., a sensor and/or a battery) within the basketball are provided.

### Summary of the invention

The object of the present invention is to provided with a device used to assemble a circuit module and a battery in a ball and the manufacturing method thereof that the ball elasticity doesn't influenced to overcome the disadvantages of the existing known technology.

The technical proposal of the present invention is that:
A device used to assemble a circuit module and battery in a ball, the device comprising an inner housing, an assembly chamber and a connecting portion and the circuit module; the circuit module is fixedly assembled in the inner housing, the inner housing is disposed in the assembly chamber, the top surface of the assembly chamber extends outwardly to form the connecting portion, an opening of the top surface of the assembly chamber is disposed with an elastic cover; the inner housing is disposed with a battery assembly position, the elastic cover is disposed with a normally-closed elastic assembly hole at the position according to the battery assembly position; said normally-closed elastic assembly hole is designed such that the battery can be pushed to the battery assembly position through the normally-closed elastic assembly hole to provide power to the circuit module, wherein the elastic cover comprises two plug covers abutting against each other to close the opening of the assembly chamber, the position the two plug covers abutting against each other is disposed with the normally-closed elastic assembly hole.

In another preferred embodiment, the battery assembly position is disposed with a conductive sheet corresponding to the electrode of the battery, the electrode of the battery contacts with the conductive sheet after the battery, which is used to supply power to the circuit module, is assembled to the battery assembly position.

In another preferred embodiment, the conductive sheet is an elastic metal sheet connected to the circuit module.

In another preferred embodiment, the conductive sheet is an arc surface extending towards the battery assembly position, the convex side of the arc surface is faced to the battery.

In another preferred embodiment, the device further comprises the battery.

In another preferred embodiment, the internal side surface of the inner housing of the battery assembly position is disposed with a guide groove, the battery is pushed along the guide groove.

In another preferred embodiment, the inner housing is disposed with a limit groove, the circuit module is limited in the limit groove.

In another preferred embodiment, the battery is a rechargeable battery; the circuit module comprises a wireless charging circuit, a receiving coil of which is disposed at the top surface of the connecting portion or is embedded in a sinking hole of the connecting portion.

In another preferred embodiment, the connecting portion is a sheet shaped connecting surface horizontally extending outwardly from the top surface of the assembly chamber.

In another preferred embodiment, a manufacturing method of a ball disposed with the device, comprising the steps:
1) assembling the circuit module in the inner housing, assembling the inner housing in the assembly chamber;
2) vulcanizing the connecting portion and the ball interior to an integration structure and wrapping the same;
3) putting the elastic cover at the top end opening of the assembly chamber, pushing the battery through the normally-closed elastic assembly hole of the elastic cover to the battery assembly position.

In another preferred embodiment, a manufacturing method of a ball disposed with the device, comprising the steps:
1) assembling the circuit module in the inner housing, assembling the inner housing in the assembly chamber;
2) adhering the connecting portion and the ball interior to an integration structure and wrapping the same, the connecting portion is disposed between the interior and the external wrapping layer;
3) putting the elastic cover at the top end opening of the assembly chamber, pushing the battery through the normally-closed elastic assembly hole of the elastic cover to the battery assembly position.

The present invention has advantages as follows:
The device used to assemble a circuit module and a battery in a ball of the present invention is provided that the battery is not fixedly connected, the interior of the ball body is formed by high temperature vulcanization and wrapped by an external layer, then the batter is pushed through the normally-closed elastic assembly hole of the elastic cover to the battery assembly position. The present invention avoids high temperature damaging the battery during the manufacturing. The elastic cover makes the ball body without weak elasticity problem at the position of the ball disposing the assembly chamber.

In the present invention, the conductive sheet can be applied with elastic metal sheet, which makes the conductive sheet contacted tightly with the electrode of the battery; during long time service, the conductive sheet would not deform due to slight vibration, it is recoverable, it would not lead to bad contact.

Based on above mentioned device, the manufacturing method of the present invention changes the traditional manufacturing processes, the present invention needn't to consider that the high temperature would damage the battery, so it needs to change the manufacturing parameter, the ball performance would be influenced, the traditional manufacturing method needs to disposed anti-damage process, which reduces the manufacturing efficiency and increases the manufacturing cost.

### Brief description of the drawings

FIG.1 illustrates a sectional diagram of the device of the present invention disposed in a ball.
FIG.2 illustrates a sectional diagram of the device.
FIG.3 illustrates a schematic diagram of the wireless coil disposed at the top surface of the connecting portion.
FIG.4 illustrates a schematic diagram of the wireless coil embedded in a sinking hole of the connecting portion.

Reference signs: connecting portion 10, assembly chamber 11, inner housing 12, circuit module 13, conductive sheet 14, battery 15, battery assembly position 16, elastic cover 17, normally-closed elastic assembly hole 18, guide groove 19, receiving coil 20, sinking hole 21.

### Detailed description of the embodiments

The present invention will be further described with the drawings and the embodiments.

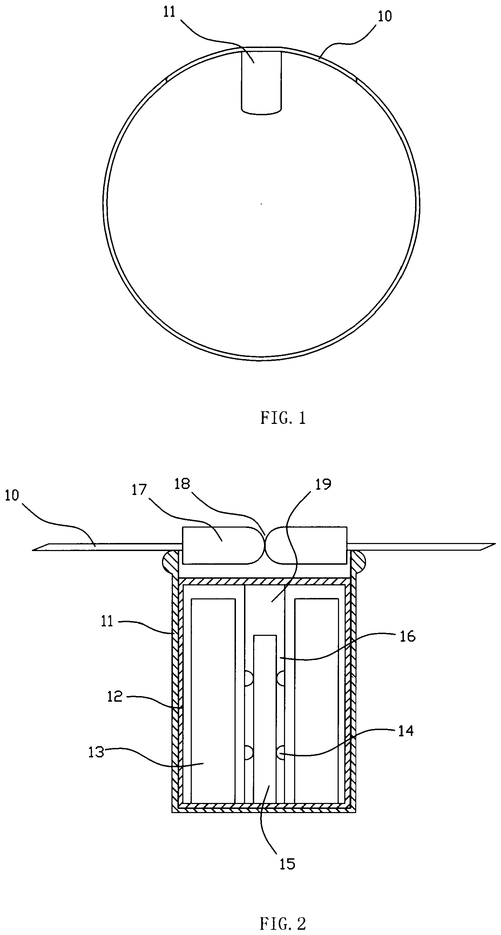

Considering that the battery 15 would be damaged and the position of the battery 15 would be weak in elasticity during high temperature vulcanization of the ball body manufactured by traditional method, the present invention is provided with a device used to assemble a circuit module 13 and a battery 15 in a ball that the elasticity of the ball is normal, as figured in FIG.1 and FIG.2, the device comprises an inner housing 12, an assembly chamber 11, a connecting portion 10, the circuit module 13 is fixedly assembled in the inner housing 12; to prevent the circuit module 13 shaking or moving in the inner housing 12, resulting in damage or data collection error, the inner housing 12 is disposed with a limit groove, and the circuit module 13 is limited and assembled in the limit groove. The circuit module 13 is tightly coupled to the limit groove, ensuring the stability of the circuit module 13 in the inner housing 12. the inner housing 12 is disposed in the assembly chamber 11, the top surface 11 of the assembly chamber extends outwardly to form the connecting portion 10; for the convenience of later process, the connecting portion 10 is a sheet shaped connecting surface extending horizontally outwardly from the top surface of the assembly chamber 11. The sheet shaped surface and the ball interior can be conveniently vulcanized to form an integrate structure; the sheet shaped surface is also convenient adhered to the ball interior and an outer leather layer.

To overcome the gap of the interior (the position disposing the assembly chamber 11), which resulting in weak elasticity of this position, the present invention is provided that the opening of the top surface of the assembly chamber 11 is disposed with an elastic cover 17, the inner housing 12 is disposed with a battery assembly position 16, the elastic cover comprises two plug covers, which are abutting against each other to close the opening of the assembly chamber, the elastic cover 17 is disposed with a normally-closed elastic assembly hole 18 at the position corresponding to the battery assembly position, the battery 15 is pushed to the battery assembly position 16 through the normally-closed elastic assembly hole 18 so as to supply power to the circuit module 13. the normally-closed elastic assembly hole 18 is kept closed due to elastic force in no working state, making the ball surface fully covered and ensuring a stronger elastic force. When to assemble the battery 15, the battery 15 is pushed to open the normally-closed elastic assembly hole 18. the battery 15 is continued to be pushed until the battery 15 is positioned at the battery assembly position 16, the normally-closed assembly hole 18 recovers to the initial state, closed state.

No matter the normally-closed elastic assembly hole 18 is situated in close state or in battery being pushed 15 state, the battery assembly position 16 in the inner housing 12 is invisible; to make sure that the battery 15 can be pushed to the battery assembly position 16 quickly and correctly, the inner side surface of the inner housing of the battery assembly position 16 is disposed with a guide groove 19, the battery 15 is pushed along the guide groove 19; the guide groove 19 can also limit the battery 15 to prevent the battery 15 from shaking in the inner housing 12.

The battery assembly position 16 is disposed with a conductive sheet 14 corresponding to the electrode of the battery 15, the electrode of the battery 15 contacts with the conductive sheet 14 after the battery 15 is assembled to the battery assembly position 16, such to supply power to the circuit module 13. To make sure that the conductive sheet 14 contacted with the electrode of the battery 15 more nicely and efficiently and to prevent bad contact after long time's service, in this embodiment, the conductive sheet 14 is an elastic metal sheet connected to the circuit module 13. The conductive sheet 14 is an arc surface extending to the battery assembly position 16, the convex conductive sheet 14 is squeezed by the battery 15 and is deformed, such to contact tightly with the electrode of the battery 15. The convex side of the arc surface of the conductive sheet 14 is faced to the battery 15, therefore, the battery 15 is pushed easily and the conductive sheet 14 would not be damaged.

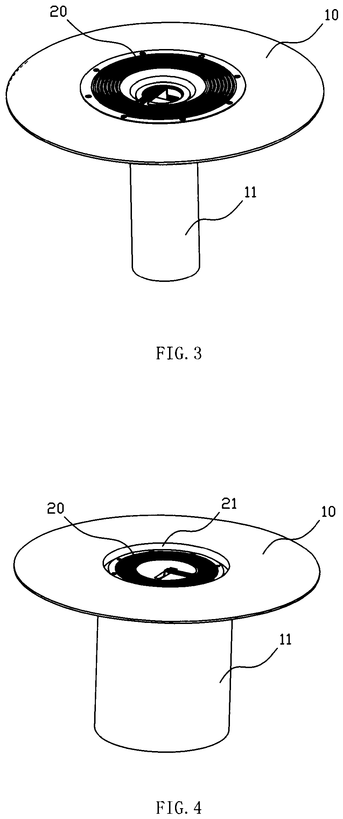

For a long time service, it should avoid changing the battery 15 frequently. In the present invention, the battery 15 is rechargeable, and the circuit module 13 comprises a wireless charging circuit, the battery 15 can be charged by wireless charging mode. The receiving coil 20 of the wireless charging circuit is disposed at the top surface of the connecting portion, as figured in FIG.3, or is embedded in the sinking hole 21 of the connecting portion 10, as figured in FIG.4, that is to say, the receiving coil 20 is contacted with the connecting portion 10; the wireless charging socket is only needed to direct to the elastic cover 17 to wireless charge the battery.

To achieve the device used to assembled a circuit module 13 and a battery 15 in a ball with normal integral elasticity, the present invention is further provided with a manufacturing method of the ball disposing with the device, the connecting portion and the ball interior can be vulcanized to an integration structure, in other cases, the connecting portion 10 can be adhered between the ball interior and the outer leather layer.

A manufacturing method of a ball disposed with the device, comprising the steps:
1) assembling the circuit module 13 in the inner housing 12, assembling the inner housing 12 in the assembly chamber 11;
2) vulcanizing the connecting portion 10 and the ball interior to an integration structure and wrapping the same (comprising splicing, stitching and other processes);
3) putting the elastic cover 17 at the top end opening of the assembly chamber 11, pushing the battery 15 through the normally-closed elastic assembly hole 18 of the elastic cover 17 to the battery assembly position 16.

Another manufacturing method of a ball disposed with the device, comprising the steps:
1) assembling the circuitmodule 13 in the inner housing 12, assembling the inner housing 12 in the assembly chamber 11;
2) adhering the connecting portion 10 and the ball interior to an integration structure and wrapping the same (comprising splicing, stitching and other processes), the connecting portion 10 is disposed between the interior and the external wrapping layer;
3) putting the elastic cover 17 at the top end opening of the assembly chamber 11, pushing the battery 15 through the normally-closed elastic assembly hole 18 of the elastic cover 17 to the battery assembly position 16.

### Industrial applicability

The device used to assemble a circuit module and a battery in a ball of the present invention is provided that the battery is not fixedly connected, the interior of the ball body is formed by high temperature vulcanization and wrapped by an external layer, then the batter is pushed through the normally-closed elastic assembly hole of the elastic cover to the battery assembly position. The present invention avoids high temperature damaging the battery during the manufacturing.

Although the present invention has been described with reference to the preferred embodiments thereof for carrying out the patent for invention, it is apparent to those skilled in the art that a variety of modifications and changes may be made without departing from the scope of the patent for invention which is intended to be defined by the appended claims.

## Claims

1. A device suitable for being used to assemble a circuit module (13) and battery (15) in a ball, the device comprising an inner housing (12), an assembly chamber (11) and a connecting portion (10) and the circuit module (13); the circuit module (13) is fixedly assembled in the inner housing (12), the inner housing (12) is disposed in the assembly chamber, the top surface of the assembly chamber extends outwardly to form the connecting portion (10), an opening of the top surface of the assembly chamber (11) is disposed with an elastic cover (17); the inner housing (12) is disposed with a battery assembly position (16), the elastic cover (17) is disposed with a normally-closed elastic assembly hole (18) at the position according to the battery assembly position (16); said normally-closed elastic assembly hole (18) is designed such that the battery (15) can be pushed to the battery assembly position (16) through the normally-closed elastic assembly hole (18) to provide power to the circuit module (13), wherein the elastic cover (17) comprises two plug covers abutting against each other to close the opening of the assembly chamber (11), the position the two plug covers abutting against each other is disposed with the normally-closed elastic assembly hole (18).

2. The device suitable for being used to assemble a circuit module (13) and a battery (15) in a ball according to claim 1, wherein the battery assembly position (16) is disposed with a conductive sheet (14) corresponding to the electrode of the battery (15), the electrode of the battery (15) contacts with the conductive sheet (14) after the battery (15), which is used to supply power to the circuit module (13), is assembled to the battery assembly position (16).

3. The device suitable for being used to assemble a circuit module (13) and a battery (15) in a ball according to claim 2, wherein the conductive sheet (14) is an elastic metal sheet connected to the circuit module (13).

4. The device suitable for being used to assemble a circuit module (13) and a battery (15) in a ball according to claim 3, wherein the conductive sheet (14) is an arc surface extending towards the battery assembly position (16), the convex side of the arc surface is faced to the battery (15).

5. The device suitable for being used to assemble a circuit module (13) and a battery (15) in a ball according to claim 1, wherein the device further comprises the battery (15).

6. The device suitable for being used to assemble a circuit module (13) and a battery (15) in a ball according to claim 1, wherein the internal side surface of the inner housing (12) of the battery assembly position (16) is disposed with a guide groove (19), the battery (15) is pushed along the guide groove (19).

7. The device suitable for being used to assemble a circuit module (13) and a battery (15) in a ball according to claim 1, wherein the inner housing (12) is disposed with a limit groove, the circuit module (13) is limited in the limit groove.

8. The device suitable for being used to assemble a circuit module (13) and a battery (15) in a ball according to claim 1, wherein the battery (15) is a rechargeable battery; the circuit module (13) comprises a wireless charging circuit, a receiving coil (20) of which is disposed at the top surface of the connecting portion (10) or is embedded in a sinking hole (21) of the connecting portion (10).

9. The device suitable for being used to assemble a circuit module (13) and a battery (15) in a ball according to claim 1, wherein the connecting portion (10) is a sheet shaped connecting surface horizontally extending outwardly from the top surface of the assembly chamber (11).

10. A manufacturing method of a ball disposed with the device according to any of claims 1∼9, comprising the steps:
1) assembling the circuit module (13) in the inner housing (12), assembling the inner housing (12) in the assembly chamber (11);
2) vulcanizing the connecting portion (10) and the ball interior to an integration structure and wrapping the same;
3) putting the elastic cover (17) at the top end opening of the assembly chamber (11), pushing the battery (15) through the normally-closed elastic assembly hole (18) of the elastic cover (17) to the battery assembly position (16).

11. A manufacturing method of a ball disposed with the device according to any of claims 1∼9, comprising the steps:
1) assembling the circuit module (13) in the inner housing (12), assembling the inner housing (12) in the assembly chamber (11);
2) adhering the connecting portion (10) and the ball interior to an integration structure and wrapping the same, the connecting portion (10) is disposed between the interior and the external wrapping layer;
3) putting the elastic cover (17) at the top end opening of the assembly chamber (11), pushing the battery (15) through the normally-closed elastic assembly hole (18) of the elastic cover (17) to the battery assembly position (16).

## Patentansprüche

1. Eine Vorrichtung, die zur Verwendung zum Zusammenbauen eines Schaltungsmoduls (13) und einer Batterie (15) in einem Ball geeignet ist, wobei die Vorrichtung ein Innengehäuse (12), eine Zusammenbaukammer (11) und einen Verbindungsteil (10) und das Schaltungsmodul (13) aufweist; das Schaltungsmodul (13) ist fest in dem Innengehäuse (12) zusammengebaut, das Innengehäuse (12) ist in der Zusammenbaukammer angeordnet, die obere Oberfläche der Zusammenbaukammer erstreckt sich nach außen, um den Verbindungsteil (10) zu bilden, eine Öffnung der oberen Oberfläche der Zusammenbaukammer (11) ist mit einer elastische Abdeckung (17) angeordnet; das Innengehäuse (12) ist mit einer Batteriezusammenbauposition (16) angeordnet, die elastische Abdeckung (17) ist mit einem normal-geschlossenen elastischen Zusammenbauloch (18) an der Position gemäß der Batteriezusammenbauposition (16) angeordnet; das normal-geschlossene elastische Zusammenbauloch (18) ist derart konstruiert, dass die Batterie (15) zu der Batteriezusammenbauposition (16) durch das normal-geschlossene elastische Zusammenbauloch (18) gedrückt werden kann, um für das Schaltungsmodul (13) Strom vorzusehen, wobei die elastische Abdeckung (17) zwei Steckerabdeckungen die aneinander anliegen, um die Öffnung der Zusammenbaukammer (11) zu schließen, aufweist, die Position der zwei aneinander anliegenden Steckerabdeckungen ist mit dem normal-geschlossenen elastischen Zusammenbauloch (18) angeordnet.

2. Die Vorrichtung, die zur Verwendung zum Zusammenbauen eines Schaltungsmoduls (13) und einer Batterie (15) in einem Ball geeignet ist, nach Anspruch 1, wobei die Batteriezusammenbauposition (16) mit einem leitenden Flächenelement (14) entsprechend der Elektrode der Batterie (15) angeordnet ist, die Elektrode der Batterie (15) kontaktiert das leitende Flächenelement (14) nachdem die Batterie (15), welche verwendet wird, Strom an das Schaltungsmodul (13) zu liefern, mit der Batteriezusammenbauposition (16) zusammengebaut ist.

3. Die Vorrichtung, die zur Verwendung zum Zusammenbauen eines Schaltungsmoduls (13) und einer Batterie (15) in einem Ball geeignet ist, nach Anspruch 2, wobei das leitende Flächenelement (14) ein elastisches Metallflächenelement ist, welches mit dem Schaltungsmodul (13) verbunden ist.

4. Die Vorrichtung, die zur Verwendung zum Zusammenbauen eines Schaltungsmoduls (13) und einer Batterie (15) in einem Ball geeignet ist, nach Anspruch 3, wobei das leitende Flächenelement (14) eine Bogenoberfläche ist, die sich zu der Batteriezusammenbauposition (16) hin erstreckt, die konvexe Seite der Bogenoberfläche ist der Batterie (15) zugewandt.

5. Die Vorrichtung, die zur Verwendung zum Zusammenbauen eines Schaltungsmoduls (13) und einer Batterie (15) in einem Ball geeignet ist, nach Anspruch 1, wobei die Vorrichtung ferner die Batterie (15) aufweist.

6. Die Vorrichtung, die zur Verwendung zum Zusammenbauen eines Schaltungsmoduls (13) und einer Batterie (15) in einem Ball geeignet ist, nach Anspruch 1, wobei die innere Seitenoberfläche des Innengehäuses (12) der Batteriezusammenbauposition (16) mit einer Führungsnut (19) angeordnet ist, die Batterie wird entlang der Führungsnut (19) gedrückt.

7. Die Vorrichtung, die zur Verwendung zum Zusammenbauen eines Schaltungsmoduls (13) und einer Batterie (15) in einem Ball geeignet ist, nach Anspruch 1, wobei das Innengehäuse (12) mit einer Begrenzungsnut angeordnet ist, das Schaltungsmodul (13) ist in der Begrenzungsnut begrenzt.

8. Die Vorrichtung, die zur Verwendung zum Zusammenbauen eines Schaltungsmoduls (13) und einer Batterie (15) in einem Ball geeignet ist, nach Anspruch 1, wobei die Batterie (15) eine wiederaufladbare Batterie ist; das Schaltungsmodul (13) weist eine drahtlose Ladeschaltung, deren Empfangsspule (20) an der oberen Oberfläche des Verbindungsteils (10) angeordnet ist oder in ein Senkloch (21) des Verbindungsteils (10) eingebettet ist, auf.

9. Die Vorrichtung, die zur Verwendung zum Zusammenbauen eines Schaltungsmoduls (13) und einer Batterie (15) in einem Ball geeignet ist, nach Anspruch 1, wobei der Verbindungsteil (10) eine flächenelementförmige Verbindungsoberfläche ist, die sich horizontal von der Oberseite der Zusammenbaukammer (11) nach außen erstreckt.

10. Ein Herstellungsverfahren eines Balls, welcher mit der Vorrichtung nach einem der Ansprüche 1∼9 angeordnet ist, das die folgenden Schritte aufweist:
1) Zusammenbauen des Schaltungsmoduls (13) in dem Innengehäuse (12), Zusammenbauern des Innengehäuses (12) in der Zusammenbaukammer (11);
2) Vulkanisieren des Verbindungsteils (10) und des Ballinneren zu einer Zusammenschlussstruktur und Einwickeln derselben;
3) Setzen der elastischen Abdeckung (17) an die obere Endöffnung der Zusammenbaukammer (11), Drücken der Batterie (15) durch das normal-geschlossene elastische Zusammenbauloch (18) der elastischen Abdeckung (17) zu der Batteriezusammenbauposition (16).

11. Ein Herstellungsverfahren eines Balls, welcher mit der Vorrichtung nach einem der Ansprüche 1-9 angeordnet ist, das die folgenden Schritte aufweist:
1) Zusammenbauen des Schaltungsmoduls (13) in dem Innengehäuse (12), Zusammenbauen des Innengehäuses (12) in der Zusammenbaukammer (11);
2) Haften des Verbindungsteils (10) und des Ballinneren zu einer Zusammenschlussstruktur und Einwickeln derselben; der Verbindungsteil (10) ist zwischen dem Inneren und der äußeren Einwicklungsschicht angeordnet;
3) Setzen der elastischen Abdeckung (17) an die obere Endöffnung der Zusammenbaukammer (11), Drücken der Batterie (15) durch das normal-geschlossene elastische Zusammenbauloch (18) der elastischen Abdeckung (17) zu der Batteriezusammenbauposition (16).

## Revendications

1. Dispositif apte à être utilisé pour monter un module de circuit (13) et une batterie (15) dans une balle, le dispositif comprenant un boîtier intérieur (12), une chambre de montage (11) et une partie de liaison (10) et le module de circuit (13) ; le module de circuit (13) est monté de manière fixe dans le boîtier intérieur (12), le boîtier intérieur (12) est disposé dans la chambre de montage, la surface supérieure de la chambre de montage s'étend vers l'extérieur pour former la partie de liaison (10), une ouverture de la surface supérieure de la chambre de montage (11) est pourvue d'un couvercle élastique (17), le boîtier intérieur (12) est pourvu d'une position de montage de batterie (16), le couvercle élastique (17) est pourvu d'un trou de montage élastique normalement fermé (18) à la position selon la position de montage de batterie (16) ; ledit trou de montage élastique normalement fermé (18) est conçu de telle sorte que la batterie (15) puisse être poussée jusqu'à la position de montage de batterie (16) à travers le trou de montage élastique normalement fermé (18) pour fournir du courant au module de circuit (13), dans lequel le couvercle élastique (17) comprend deux couvercles d'obturation butant l'un contre l'autre pour fermer l'ouverture de la chambre de montage (11), la position des deux couvercles d'obturation butant l'un contre l'autre est pourvue du trou de montage élastique normalement fermé (18).

2. Dispositif apte à être utilisé pour monter un module de circuit (13) et une batterie (15) dans une balle selon la revendication 1, dans lequel la position de montage de batterie (16) est pourvue d'une feuille conductrice (14) correspondant à l'électrode de la batterie (15), l'électrode de la batterie (15) vient en contact avec la feuille conductrice (14) après que la batterie (15), qui est utilisée pour fournir du courant au module de circuit (13), a été montée dans la position de montage de batterie (16).

3. Dispositif apte à être utilisé pour monter un module de circuit (13) et une batterie (15) dans une balle selon la revendication 2, dans lequel la feuille conductrice (14) est une feuille de métal élastique reliée au module de circuit (13).

4. Dispositif apte à être utilisé pour monter un module de circuit (13) et une batterie (15) dans une balle selon la revendication 3, dans lequel la feuille conductrice (14) est une surface en arc s'étendant vers la position de montage de batterie (16), le côté convexe de la surface en arc est dirigé vers la batterie (15).

5. Dispositif apte à être utilisé pour monter un module de circuit (13) et une batterie (15) dans une balle selon la revendication 1, dans lequel le dispositif comprend en outre la batterie (15).

6. Dispositif apte à être utilisé pour monter un module de circuit (13) et une batterie (15) dans une balle selon la revendication 1, dans lequel la surface latérale interne du boîtier intérieur (12) de la position de montage de batterie (16) est pourvue d'une rainure de guidage (19), la batterie (15) est poussée le long de la rainure de guidage (19).

7. Dispositif apte à être utilisé pour monter un module de circuit (13) et une batterie (15) dans une balle selon la revendication 1, dans lequel le boîtier intérieur (12) est pourvu d'une rainure de limitation, le module de circuit (13) est limité dans la rainure de limitation.

8. Dispositif apte à être utilisé pour monter un module de circuit (13) et une batterie (15) dans une balle selon la revendication 1, dans lequel la batterie (15) est une batterie rechargeable ; le module de circuit (13) comprend un circuit de charge sans fil dont une bobine de réception (20) est disposée sur la surface supérieure de la partie de liaison (10) ou est encastrée dans un trou de creusement (21) de la partie de liaison (10).

9. Dispositif apte à être utilisé pour monter un module de circuit (13) et une batterie (15) dans une balle selon la revendication 1, dans lequel la partie de liaison (10) est une surface de liaison en forme de feuille s'étendant horizontalement vers l'extérieur depuis la surface supérieure de la chambre de montage (11).

10. Procédé de fabrication d'une balle pourvue du dispositif selon l'une quelconque des revendications 1 à 9, comprenant les étapes :
1) monter le module de circuit (13) dans le boîtier intérieur (12), monter le boîtier intérieur (12) dans la chambre de montage (11) ;
2) vulcaniser la partie de liaison (10) et l'intérieur de la balle en une structure solidaire et enrober celle-ci ;
3) mettre le couvercle élastique (17) à l'ouverture d'extrémité supérieure de la chambre de montage (11), pousser la batterie (15) à travers le trou de montage élastique normalement fermé (18) du couvercle élastique (17) jusqu'à la position de montage de batterie (16).

11. Procédé de fabrication d'une balle pourvue du dispositif selon l'une quelconque des revendications 1 à 9, comprenant les étapes :
1) monter le module de circuit (13) dans le boîtier intérieur (12), monter le boîtier intérieur (12) dans la chambre de montage (11) ;
2) coller la partie de liaison (10) et l'intérieur de la balle en une structure solidaire et enrober celle-ci, la partie de liaison (10) est disposée entre l'intérieur et la couche d'enrobage extérieure ;
3) mettre le couvercle élastique (17) à l'ouverture d'extrémité supérieure de la chambre de montage (11), pousser la batterie (15) à travers le trou de montage élastique normalement fermé (18) du couvercle élastique (17) jusqu'à la position de montage de batterie (16).
